# EUROPEAN PATENT APPLICATION

(11) **EP 3 264 582 A1**
(43) Date of publication of application: **03.01.2018**
(21) Application number: 15883225.3
(22) Date of filing: 26.02.2015
(51) Int. Cl.: H02M 7/48

(54) **POWER CONVERSION DEVICE AND CONTROL METHOD THEREFOR**

(71) Applicant: Hitachi Industrial Equipment Systems Co., Ltd., Chiyoda-ku Tokyo 101-0022 (JP)
(72) Inventor: SASAKI Yasushi, Tokyo 101-0022 (JP); IBORI Satoshi, Tokyo 101-0022 (JP); TOMIYAMA Kiyotaka, Tokyo 101-0022 (JP)
(74) Representative: Strehl Schübel-Hopf & Partner
(86) International application number: PCT/JP2015/055670
(87) International publication number: WO 2016/135931

(57) **Abstract**

Provided is a power conversion device that can be stably operated even when a wide-bandgap semiconductor element is operated at a high temperature. Further provided is a control method for the power conversion device. This power conversion device is provided with: a rectifier that converts alternating-current power to direct-current power; an intermediate circuit that smooths the direct-current power converted by the rectifier; an inverter that converts the direct-current power smoothed by the intermediate circuit into alternating-current power; a driving circuit that drives the inverter; a control unit that controls the driving circuit; a temperature detection unit that detects the temperature of the inverter; and a sealing material that seals at least the inverter. The control unit integrates the operation time that the power conversion device continues to operate at a temperature detected by the temperature detection unit, and, on the basis of the relationship between the integrated operation time, the detected temperature, and the permitted operation time of the power conversion device, determines whether to suppress the output of the power conversion device or to stop the operation of power conversion device.

## Description

### TECHNICAL FIELD

The present invention relates to a power conversion device and a control method therefor.

### BACKGROUND ART

As a background art of this technical field, there is known JP 9-233832 A (Patent Document 1). In this document, it is described that "The characteristics such as the normally-on loss, the switching loss and the overheat impedance of the switching device of an inverter, and a switching device loss calculation formula are stored in the memory device of a control unit. By using a detected current whose waveform is close to a rectangular wave, a control factor and an output frequency as variables, the stored normally-on loss, switching loss, etc., are taken into the stored formula to obtain the loss of the switching device by the CPU of the control unit. By using the loss and the overheat impedance in the memory, a device junction temperature is calculated and the output current of the inverter is so controlled as to have the calculated junction temperature within a set temperature." (see Abstract) .

### CITATION LIST

### PATENT DOCUMENT

Patent Document 1: JP 9-233832 A

### SUMMARY OF THE INVENTION

### PROBLEMS TO BE SOLVED BY THE INVENTION

In recent years, a wide bandgap (WBG) semiconductor device capable of overcoming a physical property limitation of silicon (Si), such as silicon carbide (SiC) or gallium nitride (GaN), has attracted attention and is highlighted as a next-generation power semiconductor device. This material is a semiconductor device having characteristics such as a dielectric breakdown voltage ten times of silicon, a thermal conductivity triple of silicon, a melting point twice of silicon, a saturated electron velocity twice of silicon. Since this material has a particularly high dielectric breakdown voltage, it is possible to reduce a thickness of a drift layer for securing a withstanding pressure to approximately 1/10 and lower an ON-voltage of the power semiconductor. If a power semiconductor device is formed of such a material, it is possible to remarkably reduce a generated loss, and it is anticipated that the size of the power conversion device can be remarkably reduced, compared to an insulated-gate bipolar transistor (Si-IGBT) as a representative power semiconductor device of the related art.

Another characteristic of the WBG semiconductor device is that a high-temperature operation is allowed. In the case of the Si-based semiconductor device represented by Si-IGBT, typically, it is considered that an operation temperature limitation is set to approximately 150°C to 175°C. However, the WBG semiconductor device can be operated at a temperature of 300°C or higher, so that a high-temperature operation far exceeding that of the Si-based semiconductor device can be possible if it is compared as an element solely.

In a case where the WBG semiconductor device capable of a high-temperature operation is applied to a power conversion device, it is necessary to similarly change surrounding members such as a solder or a sealing material to a material capable of a high-temperature operation in order to operate the WBG semiconductor at a high temperature equal to or higher than that of an Si-based semiconductor device in practice. However, it may be difficult to apply such a surrounding member to the power conversion device due to cost, a manufacturing process, or a characteristic problem of a bonding material in some cases. In this case, a material having a rated operation temperature equal to an operation temperature of the Si-based semiconductor device is typically used in the surrounding member. Therefore, it is necessary to change an overheat temperature protection target from the WBG semiconductor device to the surrounding member having a heat resistance lower than that of the WBG semiconductor device. However, if the overheat protection is performed by focusing on the rated operation temperature of the surrounding member having a lower heat resistance, the operation temperature of the WBG semiconductor device remains in a level of the related art in which the Si-based semiconductor device is mounted. Therefore, advantages of the high heat resistance of the WBG semiconductor device are not utilized.

In this regard, in the overheat protection method of Patent Document 1, an increase of the device junction temperature is calculated, and an output of the inverter is restricted when the temperature increase exceeds a setting value. For this reason, if the overheat protection method of Patent Document 1 is applied to the power conversion device using the WBG semiconductor device, and the setting value is set to be lower by prioritizing protection of the surrounding member, a trip of the overheat temperature protection of the power conversion device occurs during an overheat of the WBG semiconductor device, and an operation stop or an output restriction of the power conversion device is performed. As a result, it is difficult to obtain advantages of the high-temperature operation of the WBG semiconductor device and stably drive the power conversion device. Meanwhile, if the setting value is set to be higher by prioritizing the advantages of the high-temperature operation of the WBG semiconductor device, and the WBG semiconductor device is overheated over the heat resistance of the surrounding member under the temperature of the setting value, it is difficult to protect the surrounding member from the overheat. This generates a safety problem.

In this regard, an object of the present invention is to provide a power conversion device and a control method therefor, by which both the high-temperature operation of the WBG semiconductor device and the safe operation of power conversion device can be obtained.

### SOLUTIONS TO PROBLEMS

In order to address the aforementioned problems, the present invention employs the configurations described in the claims.

According to an aspect of the present invention, there is provided a power conversion device including: a rectifier configured to convert AC power into DC power; an intermediate circuit configured to smoothen the DC power converted by the rectifier; an inverter configured to convert the DC power smoothed by the intermediate circuit into AC power; a driving circuit configured to drive the inverter; a control unit configured to control the driving circuit; a temperature detection unit configured to detect a temperature of the inverter; and a sealing material configured to seal at least the inverter, wherein the control unit integrates an operation time for which the power conversion device is continuously operated at a temperature detected by the temperature detection unit, and determines an output suppression or an operation stop of the power conversion device on the basis of a relationship between the integrated operation time, the detected temperature, and an allowable operation time of the power conversion device.

According to another aspect of the present invention, there is provided a control method for a power conversion device having a rectifier configured to convert AC power into DC power, an intermediate circuit configured to smoothen the DC power converted by the rectifier, an inverter configured to convert the DC power smoothed by the intermediate circuit into AC power, a driving circuit configured to drive the inverter, a control unit configured to control the driving circuit, a temperature detection unit configured to detect a temperature of the inverter, and a sealing material configured to seal at least the inverter, the control method comprising steps of: by the control unit, integrating an operation time for which the power conversion device is continuously operated at a temperature detected by the temperature detection unit; and by the control unit, determining an output suppression or an operation stop of the power conversion device on the basis of a relationship between the integrated operation time, the detected temperature, and an allowable operation time of the power conversion device.

### EFFECTS OF THE INVENTION

According to the present invention, it is possible to provide a power conversion device and a control method therefor, by which both the high-temperature operation of the WBG semiconductor device and the safe operation of power conversion device can be obtained.

Other objects, configurations, and effects will become clear by reading the following description of the embodiments.

### BRIEF DESCRIPTION OF THE DRAWINGS

Fig. 1 illustrates an exemplary configuration of a power conversion device according to a first embodiment.
Fig. 2 illustrates an exemplary internal circuit configuration of a rectifier and an inverter of a power conversion device of the related art.
Fig. 3 illustrates an exemplary configuration of a semiconductor module of the related art.
Fig. 4 is a conceptual diagram illustrating an operation for protecting a power conversion device having a temperature protection/detection circuit provided with a Si-based semiconductor device in a case where a temperature sensor is embedded in the semiconductor device itself of the related art.
Fig. 5 is a conceptual diagram illustrating an operation for protecting a power conversion device having a temperature protection/detection circuit provided with a Si-based semiconductor device in a case where a temperature is detected using a thermistor of the power conversion device of the related art.
Fig. 6 illustrates a test result relating to a weight loss of epoxy at a high temperature.
Fig. 7 is a de-rating curve illustrating a relationship between each temperature and an allowable operation time t(T) according to the first embodiment.
Fig. 8 is a flowchart illustrating a temperature protection control according to the present invention.
Fig. 9 is a de-rating curve illustrating a relationship between each temperature and an allowable operation time t(T) according to a third embodiment.
Fig. 10 is a de-rating curve illustrating a relationship between each temperature and an allowable operation time t(T) according to a fourth embodiment.
Fig. 11 is a de-rating curve illustrating a relationship between each temperature and an allowable operation time t(T) according to a fifth embodiment.

### MODE FOR CARRYING OUT THE INVENTION

Embodiments of the present invention will now be described with reference to the accompanying drawings. The embodiments described below are not limited to those illustrated in the drawings.

### <First Embodiment>

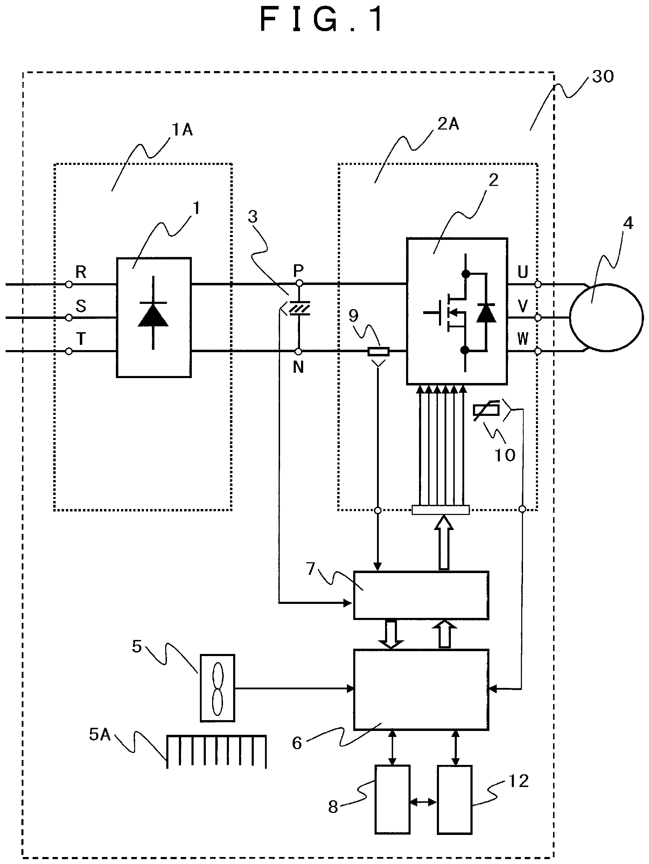

Fig. 1 is an exemplary configuration of a power conversion device according to a first embodiment. The power conversion device 30 of Fig. 1 includes a rectifier 1, an inverter 2, a smoothing capacitor 3, a cooling fan 5, a cooling fin 5A, a control circuit 6, a driving circuit 7, a digital control panel 8, a shunt resistance 9, and a memory unit 12. In Fig. 1, it is assumed that an alternating current (AC) power source (not shown) is used as an arbitrary input power source. The rectifier 1 converts AC power supplied from an AC power source to direct current (DC) power. The smoothing capacitor 3 is provided in a DC intermediate circuit to smoothen the DC power converted by the rectifier 1. The inverter 2 has a wide-bandgap (WBG) semiconductor switching element and converts the DC power smoothened by the smoothing capacitor into AC power having an arbitrary frequency by driving the semiconductor switching element. The AC power converted by the inverter is output to, for example, a connected AC motor 4.

Note that the WBG semiconductor is formed of SiC, GaN, or the like. In addition, a metal oxide semiconductor field effect transistor (MOSFET) or a junction FET (j-FET) is employed as the WBG semiconductor-based switching element. In addition, a SiC-based shottky barrier diode (SBD) may be employed as a freewheeling diode connected in antiparallel to the SiC-based MOSFET semiconductor switching element. Alternatively, the freewheeling diode may not be provided in some cases. In this case, it is possible to reduce the number of components.

A temperature protection/detection circuit is mounted inside the inverter 2, and a thermistor 10 of Fig. 1 is mounted to detect a temperature. In addition, a temperature detection function is embedded in a semiconductor device of the inverter in some cases.

The cooling fan 5 introduces the ambient air to the inside to cool the inside of the power conversion device 30. The cooling fin 5A radiates heat generated from the rectifier 1, the inverter 2, or the like to the outside in a heat conduction manner. The driving circuit 7 drives the inverter 2, and the control circuit 6 (control unit) controls operations of the entire power conversion device 30 including the cooling fan and the driving circuit 7. The digital control panel 8 is used to input various data and display data received from the control unit or the memory unit 12, or the like. The shunt resistance 9 is used to monitor a current value of the power conversion device 30. The memory unit 12 stores input values of various data of the digital control panel 8, input values from the control unit 6, or the like and outputs the stored input value or data to the digital control panel 8 or the control unit 6.

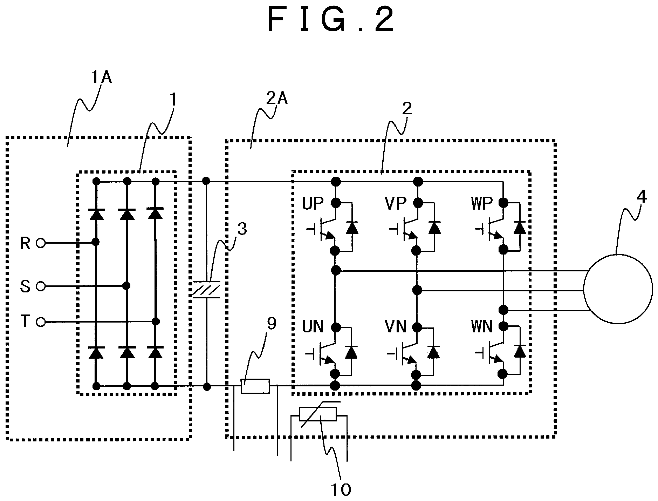

Here, a temperature protection control of the related art will be described with reference to Figs. 2 to 5.

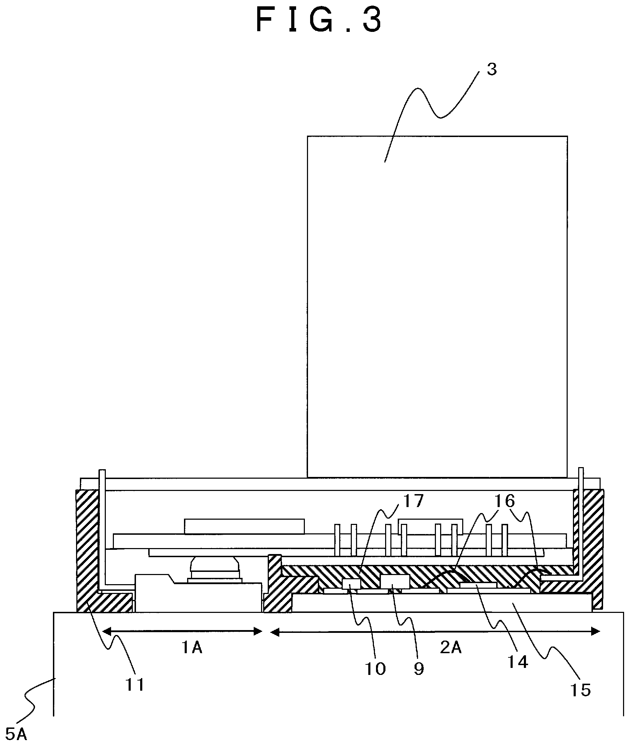

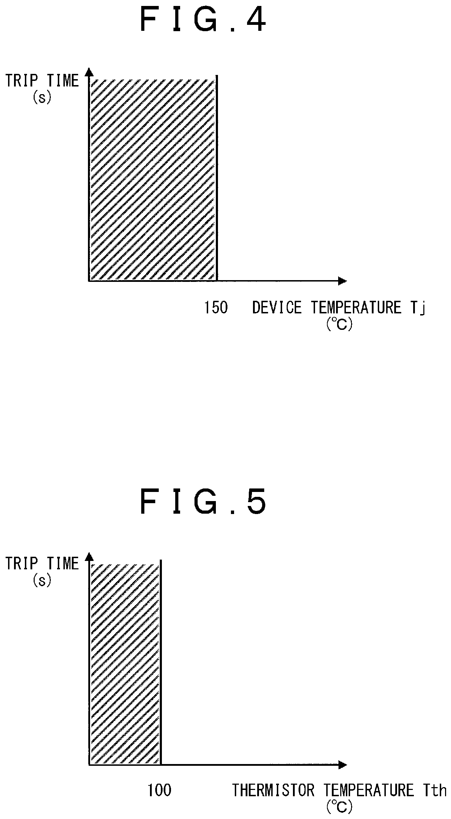

Fig. 2 illustrates an exemplary internal circuit configuration of the rectifier and the inverter of the power conversion device of the related art. Fig. 3 illustrates an exemplary configuration of the semiconductor module of the related art. Fig. 4 is a conceptual diagram illustrating an operation for protecting the power conversion device 30 having the temperature protection/detection circuit provided with a Si-based semiconductor device in a case where a temperature sensor is embedded in the semiconductor device itself of the related art. Fig. 5 is a conceptual diagram illustrating an operation for protecting the power conversion device 30 having the temperature protection/detection circuit provided with a Si-based semiconductor device in a case where a temperature is detected using the thermistor 10 of the power conversion device 30 of the related art.

Fig. 2 illustrates an exemplary internal circuit configuration of the rectifier 1 and the inverter 2 of the related art. In Fig. 2, the inverter 2 includes a Si-based insulated gate bipolar transistor (IGBT) and a Si-based fast recovery diode (FRD). This is a most typical semiconductor module type at this time. The Si-based IGBT is a semiconductor switching element and converts DC power into AC power by turning on or off the switching element using the driving circuit 7. The Si-based FRD supplies a freewheeling current flowing from the AC motor 4 when the Si-based IGBT is turned off.

Fig. 3 illustrates an exemplary configuration of the semiconductor module of the related art. The semiconductor module has a rectifier module 1A and an inverter module 2A housed in a module casing 11. In the case of the Si-based semiconductor device, a temperature of 150°C to 175°C is generally set as an operation guarantee temperature. For this reason, in the power conversion device 30, the temperature is monitored using the thermistor 10 or the like at all times while the operation is performed such that a temperature of the switching semiconductor device mounted in the inverter 2 and represented by Si-MOSFET or Si-IGBT typically having the highest temperature does not exceed the operation guarantee temperature.

The Si-based semiconductor device is formed on a bare chip 14 and is packaged in an insulation substrate 15 using a bonding material typically represented by a solder in the power conversion device. In addition, a sealing material 17 represented by resin such as epoxy or silicon gel is filled around the bare chip 14 or a bonding wire 16 that electrically connects the bare chip and each element (such as a shunt resistance 9) on the insulation substrate to protect them. A portion of the surrounding member making contact with the semiconductor device has substantially the same temperature as that of the semiconductor device. Therefore, similarly, it is necessary to select a material having an operation guarantee temperature of 150°C to 175°C for the surrounding member of the semiconductor device.

In general, if the solder is re-molten after the packaging, an unnecessary chemical or physical stress is applied to a plated layer or a wire bonding surface on a back face of the semiconductor device, and this directly affects degradation of reliability. Therefore, it is necessary to avoid the temperature of the solder from exceeding the melting point even in an instant. For this reason, the solder is formed of a material having a melting point apparently higher than the operation temperature of the semiconductor device. A typical SnAg-based Pb-free solder has a melting point of 215 to 220°C, which is significantly higher than the silicon operation guarantee temperature of 150°C described above. If a solder having a higher melting point is employed by combining composition metals, it is possible to set the operation guarantee temperature endurable to the high-temperature operation of the WBG semiconductor device.

Meanwhile, compared to a solder having a melting point that can be controlled relatively easily by changing a combination of the composition metals, in general, the sealing material is a material that is difficult to guarantee the high-temperature operation. This is because, for example, in the case of epoxy-based resin, characteristics of various inherent organic components change due to a reaction at a high temperature, or a part of the components are decomposed and escaped to the outside. The former is represented by the glass transition temperature, and the latter is represented by a weight loss phenomenon and the like. For this reason, the epoxy-based resin typically has an operation guarantee temperature of approximately 150°C, which is equal to that of the silicon, out of relatively high-temperature operation materials.

In this manner, in the case of resin such as epoxy, the sealing material 17 typically has a usable rated temperature based on the glass transition temperature. However, unlike a melting temperature, the rated temperature is a temperature of the changing point at which a characteristic such as an expansion coefficient begins to change. The characteristic does not reach a level at which a problem of the product quality immediately occurs within a short time even when the temperature rises over the rated temperature.

Therefore, within a temperature range lower than the melting temperature of the solder, it is possible to drive the power conversion device with excellent sustainability that does not immediately generate a trip even in the high-temperature operation over a usable temperature at which the power conversion device can be used in the silicon chip of the related art, by performing a control such that the operation time is restricted when the temperature exceeds the rated temperature of the sealing material.

Fig. 4 is a conceptual diagram illustrating an operation for protecting the power conversion device 30 having the temperature protection/detection circuit provided with the Si-based semiconductor device in a case where a temperature sensor is embedded in the Si-based semiconductor device itself. In this case, since there is nearly no time lag between the detection temperature Tj and the actual temperature of the Si-based semiconductor device, it is possible to continuously drive the power conversion device to a temperature of 150°C by setting the operation guarantee temperature to 150°C as illustrated in Fig. 4. However, once the detection temperature exceeds 150°C, a control such as an operation stop or an output restriction of the power conversion device 30 is performed to protect the Si-based semiconductor device from overheating.

Meanwhile, Fig. 5 is a conceptual diagram illustrating an operation for protecting the power conversion device 30 having the temperature protection/detection circuit provided with the Si-based semiconductor device in a case where a temperature is detected using a thermistor 10 of the power conversion device 30. In this case, since a time lag is generated in the temperature Tth of the thermistor mount portion relative to the highest temperature portion of the Si-based semiconductor device, a protection depending on temperature detection of the thermistor 10 is typically applied at a temperature lower than the operation guarantee temperature of the semiconductor device or the sealing material in advance as illustrated in Fig. 5. Fig. 5 illustrates a case where the temperature is set to 100°C. However, it is necessary to select an appropriate temperature depending on a position of the thermistor or the like.

For example, if the thermistor 10 is installed in the vicinity of the Si-based semiconductor device, the time lag between the temperature of the Si-based semiconductor device and the temperature detected by the thermistor is reduced. Therefore, a high operation guarantee temperature may be set. In contrast, if the thermistor 10 is installed far from the Si-based semiconductor device, this time lag increases, so that a low operation guarantee temperature may be set.

Hereinbefore, the temperature protection in the operation of the power conversion device of the related art has been described in brief.

Here, it is assumed that the Si-based semiconductor device is substituted with a WBG semiconductor device. An operable temperature of the WBG semiconductor device is higher than that of the Pb-free solder, and the WBG semiconductor device can be operated even at a temperature of 300°C or higher without a breakdown. In this case, the solder as a surrounding member can be substituted with a solder having a higher melting point or a non-solder-based high melting point metal such as a silver sintering material. However, the material cost or the manufacturing process still falls short of those of the solder of the related art.

Although researches have been made for the sealing material 17 or highly heat-resistant resin capable of a high-temperature operation, there are still many problems in the reasonable mass productivity as in the solder substitution material. Therefore, it is also assumed that the solder and the sealing material of the related art are employed for the time being except for the parts requiring the high-temperature operation.

Here, compared to Si-IGBT, the WBG semiconductor device advantageously has a lower loss as well as capability of the high-temperature operation. For this reason, it is possible to maintain a temperature increase level as high as that of the silicon of the related art even when it is miniaturized to some extent. If the control of the related art by which the operation temperature of a 150°C level is maximized is performed, it is possible to obtain an advantage of the low loss of the WBG semiconductor device. However, in a case where further miniaturization is desired, or the operation is carried out under a high temperature environment higher than that of the related art, the temperature of the WBG semiconductor device may possibly exceed the operation temperature of a 150°C level. In this case, needless to say, the WBG semiconductor device itself can also operate at a high temperature, but the surrounding member for mounting the WBG semiconductor element such as the solder and the sealing material is also required to be free from a problem at the same high temperature. If such a usable temperature of the solder and the sealing material is lower than that of the WBG semiconductor device, the power conversion device may fail to fully utilize the characteristics of the WBG semiconductor device as a result.

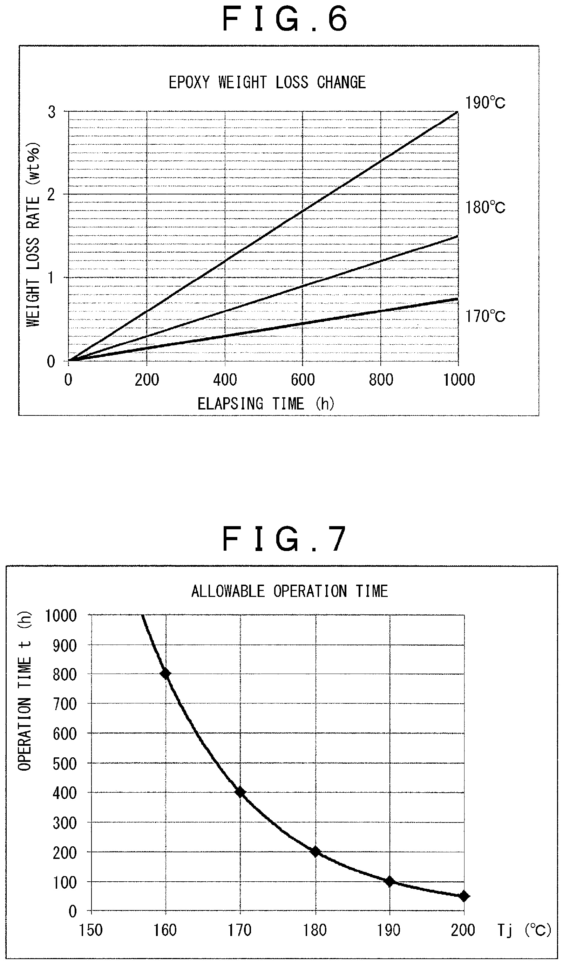

Here, taking into consideration of the epoxy of the sealing material by way of example, if the temperature exceeds the glass transition temperature Tg, the linear expansion coefficient increases, and the thermal stress increases accordingly. In addition, when a Br-based flame retardant begins to decompose at a high temperature, a weight loss of the epoxy occurs in many cases. Fig. 6 illustrates an example of the test result relating to the weight loss of epoxy at a high temperature. Generally, if the weight decreases by approximately 3%, a deformation such as a crack or bulging occurs in the resin in many cases. Therefore, the weight loss of 3% is said to be a reference of the weight loss allowance. In a case where the temperature exceeds the glass transition temperature, the influence of the linear expansion coefficient does not contribute to a change in stress unless the operation state of the power conversion device 30 significantly changes, and temperature is fluctuated. However, as illustrated in Fig. 6, the weight loss of epoxy progresses by itself while the high temperature state is maintained. In addition, a rate of the weight loss of epoxy is different depending on the holding temperature. Therefore, it is necessary to pay more attention to the weight loss of epoxy during a high-temperature operation of the semiconductor device.

According to the present invention, paying attention to this fact, a safe operation can be performed by operating the power conversion device within a short time even when the temperature of the WBG semiconductor device exceeds the operation temperature of the epoxy sealing material, and controlling the weight loss in the case of a continuous operation for a long time. Note that, although the weight loss is employed as a characteristic to be controlled in the present invention by way of example, alternatively, an operation control may be performed by prioritizing a material suffering from aging at a constant high temperature. Preferably, a characteristic that the deterioration progresses fastest at a high temperature is set as a control target.

The temperature protection control according to the present invention will be described with reference to Figs. 6 and 7. Fig. 7 is a de-rating curve illustrating a relationship between each temperature of the first embodiment and the allowable operation time t(T). In the de-rating curve of Fig. 7, a relationship between each temperature and the allowable operation time t(Tj) is illustrated by assuming that a temperature Tj is obtained by directly detecting a temperature of the WBG semiconductor device using a temperature sensor or the like provided in the WBG semiconductor device. The de-rating curve of Fig. 7 is obtained by plotting some points of times at which the weight loss reaches 0.3% at a constant temperature in Fig. 6 and approximating them as a function. Note that, although the reference of the weight loss allowance is set to 3% in the explanation of Fig. 6, a sufficient margin is further added thereto, so that the allowable operation time is determined by setting the weight loss of 0.3% level of "1/10" as an upper limit. Since this upper limit represents a margin of reliability, needless to say, it is necessary to set it to a suitable level on a product-by-product basis.

Note that, in Fig. 7, as the number of plots increases, the accuracy of the function increases. Therefore, it is possible to manage the allowable operation time at each temperature with higher accuracy.

In this temperature protection control, in a case where the temperature exceeds 150°C which is the operation guarantee temperature of epoxy, a control having a time-limited characteristic (allowable operation time) is performed for the operable time. In Fig. 7, since it is assumed that a temperature detection element is formed in the semiconductor device itself, and the temperature Tj of the WBG semiconductor device is directly detected from the semiconductor device, the operation time is de-rated at a temperature of 150°C or higher. Note that the de-rating curve is determined depending on the characteristics of the resin or the margin corresponding to a temperature detection position of the WBG semiconductor device, and it is not limited to the example of this drawing.

In this temperature protection control, as illustrated in Fig. 7, the allowable operation time is set depending on each temperature. In addition, in a case where the time for which the power conversion device 30 is operated at a temperature equal to or higher than the operation guarantee temperature of epoxy exceeds the allowable operation time, an operation such as an operation stop or an output restriction of the power conversion device 30 is performed. That is, for example, in a case where the power conversion device 30 is driven while the detected temperature is equal to or higher than 170°C, the power conversion device 30 is continuously driven until 400 h. In addition, if the operation time of the power conversion device 30 exceeds 400 h in this state, the operation enters an output restriction driving mode in which the temperature is lowered by reducing the output current of the power conversion device 30 or reducing the switching frequency of the WBG semiconductor device. In addition, in a case where the temperature is not lowered even after a predetermined time t0 in the output restriction driving mode, the operation stop of the power conversion device is forcedly performed.

As a result, even when the WBG semiconductor device becomes a high temperature, and its temperature exceeds the operation guarantee temperature of epoxy, it is possible to continuously and stably drive the power conversion device 30 as long as the epoxy can be safely used without an operation stop or an output restriction of the power conversion device 30.

In this temperature protection control, the present invention is not limited to the continuous curve of Fig. 7. For example, in a case where decomposition of the flame retardant or melting of the solder occurs suddenly from a certain temperature, the allowable operation time may be set to zero at a temperature equal to or higher than this temperature. As a result, it is possible to immediately stop the operation of the power conversion device 30 and restrict the output if the detected temperature is equal to or higher than this temperature while the power conversion device 30 is operated within a safe range. Therefore, it is possible to safely drive the power conversion device 30.

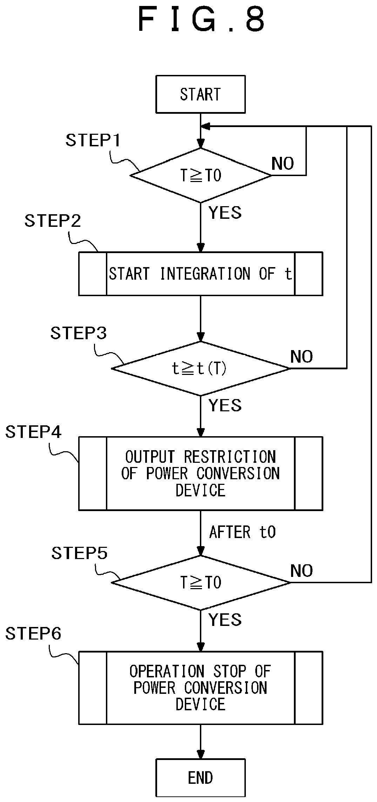

Each operation and their flows in this temperature protection control will be described with reference to Figs. 1 and 8. Fig. 8 is a flowchart illustrating the temperature protection control according to the present invention. In this temperature protection control, the temperature is controlled using a microcomputer embedded in the control circuit 6 (control unit) of Fig. 1 and depending on a temperature directly detected from the semiconductor device or a temperature detected from the thermistor 10. The allowable operation times t(T) for each temperature are stored in the memory unit 12, for example, depending on the epoxy operation guarantee margin in advance.

The control unit determines whether or not the detected temperature T is equal to or higher than a predetermined temperature T0 (step 1). In the aforementioned embodiment, the predetermined temperature T0 is set to 150°C. If the detected temperature is equal to or higher than the predetermined temperature, the control unit starts integration of the operation time t of the power conversion device 30 at this temperature depending on the detected temperature (step 2), and determines whether or not the integrated operation time t exceeds the allowable operation time t(T) stored in the memory unit 12 (step 3). If the integrated operation time exceeds the allowable operation time, the control unit performs the output restriction of the power conversion device 30 (step 4). In addition, the control unit determines whether or not a temperature T detected after a predetermined time t0 is equal to or higher than a predetermined temperature T0 (step 5). If (T) ≥ (T0), the control unit stops the operation of the power conversion device 30 (step 6). Here, if the operation time t integrated in step 3 does not exceed the allowable operation time t(T), or if T < T0 in step 5, the control unit returns to step 1, and determines whether or not T ≥ T0. As a result, it is possible to stop the integration of the operation time if T < T0 while the operation time is integrated under the condition T ≥ T0.

Note that, in this case, assuming that the integration time t for each temperature T equal to or higher than T0 is not initialized, and information as a total operation time at a high temperature of the power conversion device is stored, the control unit starts integration of the operation time starting from the stored integration time t if T ≥ T0 in step 1 again.

Note that any type of memory such as a hard disk drive (HHD) or a solid state drive (SSD) may be employed as the memory unit 12 as long as it can store a relationship between each temperature and the allowable operation time. In addition, the memory unit 12 may be provided in the power conversion device 30 or may be externally provided. Furthermore, all of the temperature protection controls may be performed on the basis of the control of the external device. In this case, signals are exchanged with external devices through an external input/output terminal (not shown).

According to this embodiment, in a case where the surrounding member represented by the sealing material such as epoxy is used at a temperature equal to or higher than the operation guarantee temperature, it is possible to protect the surrounding member by managing its state. In addition, even when the detected temperature exceeds the operation guarantee temperature, the power conversion device 30 can continuously perform a stable operation without the operation stop or the output restriction. That is, since the driving stop caused by a temperature protection trip of the power conversion device during a high-temperature operation is suppressed while safety is maintained, it is possible to obtain a tripless power conversion device having excellent continuous operation performance.

### <Second Embodiment>

In this embodiment, an example of a control for adding, to the first embodiment described above, a control algorithm for calculating a remaining time of the allowable operation time by integrating the operation time at each temperature will be described. Like reference numerals denote like elements as in the first embodiment, and they will not be described repeatedly. This embodiment will be described with reference to Fig. 7.

A case where, for example, the WBG semiconductor device is operated at a temperature of 170°C and 180°C for 100 h will be described. Referring to Fig. 7, since the allowable operation time for the temperatures of 170°C and 180°C are 400 h and 200 h, respectively, the continuous operation time becomes 1/4 and 1/2, respectively, of the allowable operation times. Therefore, it can be said that 3/4 of the allowable operation time at each temperature allowable within a range equal to or higher than 150°C is consumed in total. Therefore, in a case where the WBG semiconductor device is operated at a temperature of 170°C in the next operation, the remaining part 1/4 of the total allowable operation time at a temperature of 170°C, that is, 100 h is the operable time until the remaining time of the allowable operation time is consumed.

In this case, if the operation time exceeds 100 h at a temperature of 170°C, it is determined that the remaining time of the allowable operation time that can be operated in the high-temperature operation equal to or higher than 150°C is zero. In addition, an output restriction driving mode is executed, in which the temperature is lowered more by reducing the output current of the power conversion device 30 or reducing the switching frequency of the WBG semiconductor device. In addition, in a case where the temperature is not lowered even after a predetermined time in the output restriction driving mode, the operation stop of the power conversion device is forcedly performed. As a result, it is possible to more reliably protect the sealing material. In addition, in the next operation, a temperature of 150°C is newly set as a highest operation temperature of the semiconductor module, and the power conversion device 30 determines the output restriction mode or the operation stop regardless of the operation time. Such a control and memorization of each driving state are performed using the control circuit 6 (control unit) of Fig. 1.

Note that the time for which the detected temperature of the WBG semiconductor device is equal to or higher than the operation guarantee temperature is integrated using a microcomputer or a hardware configuration such as a timer circuit.

In this manner, by integrating the operation time at each temperature and calculating the remaining time of the allowable operation time at each temperature, it is possible to manage the allowable operation time with excellent accuracy depending on an operation situation of the power conversion device 30. As a result, it is possible to protect the surrounding member even when the WBG semiconductor device has a temperature equal to or higher than the operation guarantee temperature of the surrounding member. Therefore, it is possible to more stably and safely drive the power conversion device 30.

### <Third Embodiment>

In this embodiment, an example of the temperature protection control in a case where the temperature of the WBG semiconductor device is detected using the thermistor 10 in the first or second embodiment will be described. Like reference numerals denote like elements as in the first or second embodiment, and they will not be described repeatedly.

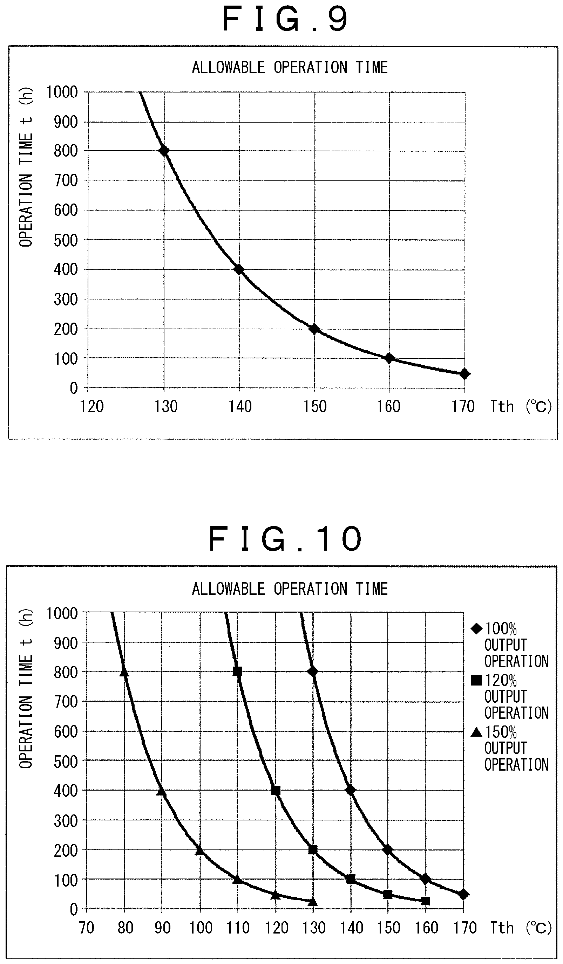

Fig. 9 is a de-rating curve illustrating a relationship between each temperature of the third embodiment and the allowable operation time t(T). In the de-rating curve of Fig. 9, a relationship between each temperature and the allowable operation time t(Tth) is illustrated by assuming a temperature Tth is detected by indirectly detecting the temperature of the WBG semiconductor device using a thermistor or the like. The allowable operation time of Fig. 7 is obtained by assuming a case where the temperature of the WBG semiconductor device can be directly detected from the device. However, generally, the temperature of the semiconductor module is detected using the thermistor 10 as illustrated in Figs. 1 and 2 in many cases. In a case where the temperature is detected using the thermistor 10 of the semiconductor module, a time lag of the temperature increase is generated between the highest temperature portion of the WBG semiconductor device and the mount portion of the thermistor 10. For this reason, as described above, protection is applied by setting a temperature of the thermistor to be lower than the operation guarantee temperature of the WBG semiconductor device or the sealing material in advance as illustrated in Fig. 5.

Therefore, Fig. 9 is a de-rating curve illustrating a relationship between the temperature Tth detected by the thermistor and the allowable operation time by considering a time lag of the temperature increase in Fig. 7. In Fig. 7, the de-rating curve starting from 150°C is an example starting from 120°C. It is necessary to appropriately select the de-rating start temperature depending on a position of the thermistor 10 or the like. That is, the allowable operation time changes depending on a distance between the WBG semiconductor device and the thermistor. This de-rating curve is stored in the memory unit 12, and the control unit appropriately refers to the de-rating curve from the memory unit to determine whether or not the integrated operation time t exceeds the allowable operation time t(T).

As described above, according to this embodiment, the allowable operation time is changed on the basis of the distance between the semiconductor switching element and the temperature detector (thermistor 10). Therefore, even when the temperature is detected using the thermistor 10, it is possible to manage the surrounding member with excellent accuracy and stably perform a safe operation of the power conversion device 30.

### <Fourth Embodiment>

In this embodiment, an example in which a control for changing the allowable operation time depending on an output current of the power conversion device 30 is added to any one of the first to third embodiments will be described with reference to Fig. 10. Like reference numerals denote like elements as in the first to third embodiments, and they will not be described repeatedly.

Fig. 10 is a de-rating curve illustrating a relationship between each temperature Tth and the allowable operation time t(T) according to the fourth embodiment. The temperature of the semiconductor device mounted on the semiconductor module changes depending on a received voltage or an output current value of the power conversion device and significantly depends on the output current value. In the de-rating curves of Figs. 7 and 9, it is assumed that the rated current is output from the power conversion device. However, the power conversion device typically has a capability of allowing an excessive current output equal to or higher than the rated value within a short time. In this case, the device temperature in the semiconductor module increases instantly. For this reason, in the temperature detection using the thermistor 10, the time lag is generated longer than the temperature rising time of Fig. 9. Therefore, a faster de-rating start is necessary.

Considering that the time lag is different depending on the overcurrent level, it is effective to allow the control circuit 6 (connector unit) of Fig. 1 to have a capability of preparing de-rating curves (relationship between the temperature and the allowable operation time) suitable for each overcurrent level in the memory unit 12 in advance and performing the selected control at an appropriate time. An example of the de-rating curve for each overcurrent level in this case is illustrated in Fig. 10. The overcurrent level may be set more accurately, or a representative curve suitable for each range of the overcurrent level may also be selected. Such a de-rating curve is stored in the memory unit 12, and the control unit appropriately refers to this curve from the memory unit to determine whether or not the integrated operation time t exceeds the allowable operation time t(T).

As described above, according to this embodiment, the allowable operation time at each temperature is set by considering the overcurrent. Therefore, it is possible to manage the surrounding member with higher accuracy and stably perform the safe operation of the power conversion device 30.

### <Fifth Embodiment>

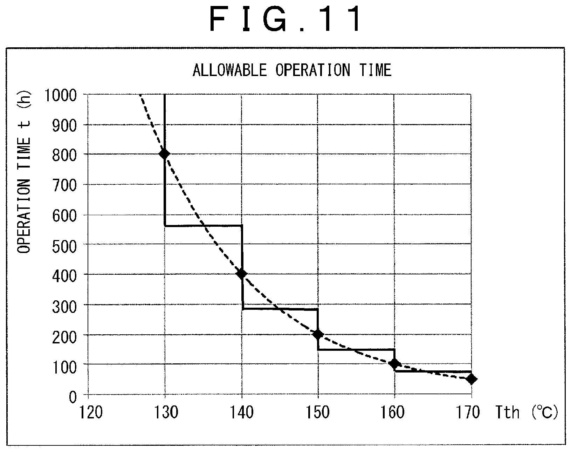

In this embodiment, an example in which the temperature protection control is performed by setting the allowable operation time on the basis of a stepwise de-rating curve in the first to fourth embodiment will be described with reference to Fig. 11. Like reference numerals denote like elements as in the first to fourth embodiments, and they will not be described repeatedly.

Fig. 11 is a de-rating curve illustrating a relationship between each temperature Tth and the allowable operation time t(T) in the fifth embodiment. The de-rating curves of Figs. 7, 9, and 10 are continuous curves illustrating the detected temperature and the allowable operation time of the power conversion device 30 depending on the detected temperature. However, in order to reduce a computation load of the control circuit 6 (control unit) of Fig. 1, this de-rating curve of Fig. 11 is created by intentionally setting the allowable operation time in a stepwise manner. In this protection of such a level, as long as epoxy resin is employed, it is possible to sufficiently perform the protection by setting the allowable operation time for each predetermined temperature range and appropriately adjusting the temperature width of the stepwise curve because instant decomposition does not occur unlike the solder. This stepwise de-rating curve is stored in the memory unit 12, and the control unit appropriately refers to this curve from the memory unit to determine whether or not the integrated operation time t exceeds the allowable operation time t(T).

As described above, according to this embodiment, the allowable operation time is set for each predetermined temperature range. Therefore, it is possible to manage the surrounding member and stably perform the safe operation of the power conversion device while reducing the computation load of the control unit.

Note that the present invention is not limited to the aforementioned embodiments, and may be modified in various manners. For example, while the aforementioned embodiments have been described in details for facilitating understanding of the present invention, all of the components described above are not necessarily provided. In addition, a part of the components of a certain embodiment may be substituted with components of other embodiments, and a configuration of a certain embodiment may be added to configurations of other embodiments. Furthermore, any addition, deletion, or substitution for a part of the configuration of each embodiment may also be possible.

For example, although the WBG semiconductor device is employed in the first to fifth embodiments, the same functional effects described in the first to fifth embodiments of the present invention can be obtained in a case where a Si-based semiconductor device of the related art is employed, or in a case where a surrounding member having the operation guarantee temperature lower than that of the Si-based semiconductor device is employed.

In addition, although control lines or an information lines necessary for description purposes are illustrated, all of control lines and information lines on a product are not necessarily illustrated. In practice, it may be conceived that most of the configurations are connected to each other.

### REFERENCE SIGNS LIST

- 1: rectifier
- 2: inverter
- 3: smoothing capacitor
- 4: AC motor
- 5: cooling fan
- 6: control circuit
- 7: driver circuit
- 8: digital control panel
- 9: shunt resistance
- 10: thermistor
- 11: module casing
- 12: memory unit
- 1A: rectifier module
- 2A: inverter module
- 5A: cooling fin
- 14: bare chip
- 15: insulation substrate
- 16: bonding wire
- 17: sealing material
- 30: power conversion device

## Claims

1. A power conversion device comprising:
a rectifier configured to convert AC power into DC power;
an intermediate circuit configured to smoothen the DC power converted by the rectifier;
an inverter configured to convert the DC power smoothed by the intermediate circuit into AC power;
a driving circuit configured to drive the inverter;
a control unit configured to control the driving circuit;
a temperature detection unit configured to detect a temperature of the inverter; and
a sealing material configured to seal at least the inverter,
wherein the control unit integrates an operation time for which the power conversion device is continuously operated at a temperature detected by the temperature detection unit, and determines an output suppression or an operation stop of the power conversion device on the basis of a relationship between the integrated operation time, the detected temperature, and an allowable operation time of the power conversion device.

2. The power conversion device according to claim 1, wherein the control unit integrates the operation time of the power conversion device if the detected temperature is equal to or higher than a predetermined temperature, and
the control unit determines the output suppression or the operation stop of the power conversion device if a total of integrated operation time exceeds the allowable operation time.

3. The power conversion device according to claim 1, wherein the control unit calculates a remaining time of the allowable operation time at each temperature on the basis of the temperature detected by the temperature detection unit and the operation time integrated at each temperature.

4. The power conversion device according to claim 1, wherein the inverter has a semiconductor-based switching element that is driven by the driving circuit and has a bandgap wider than that of silicon.

5. The power conversion device according to claim 1, further comprising a power module provided with the inverter,
wherein the inverter has a semiconductor switching element driven by the driving circuit, and
the temperature detection unit is provided in the semiconductor switching element or the power module.

6. The power conversion device according to claim 5, wherein the temperature detection unit is provided in the power module, and
the control unit changes the allowable operation time on the basis of a distance between the temperature detection unit and the semiconductor switching element.

7. The power conversion device according to claim 1, further comprising a current detection unit configured to detect an electric current flowing through the inverter,
wherein the control unit changes the allowable operation time on the basis of a current value detected by the current detection unit.

8. The power conversion device according to claim 1, wherein the control unit determines the allowable operation time of the power conversion device for each predetermined detected temperature range.

9. A control method for a power conversion device having a rectifier configured to convert AC power into DC power, an intermediate circuit configured to smoothen the DC power converted by the rectifier, an inverter configured to convert the DC power smoothed by the intermediate circuit into AC power, a driving circuit configured to drive the inverter, a control unit configured to control the driving circuit, a temperature detection unit configured to detect a temperature of the inverter, and a sealing material configured to seal at least the inverter, the control method comprising steps of:
by the control unit, integrating an operation time for which the power conversion device is continuously operated at a temperature detected by the temperature detection unit; and
by the control unit, determining an output suppression or an operation stop of the power conversion device on the basis of a relationship between the integrated operation time, the detected temperature, and an allowable operation time of the power conversion device.

10. The control method for the power conversion device according to claim 9, further comprising steps of:
by the control unit, integrating the operation time of the power conversion device if the detected temperature is equal to or higher than a predetermined temperature;
by the control unit, comparing a total of the integrated operation time and the allowable operation time; and
by the control unit, determining the output suppression or the operation stop of the power conversion device if the total of the integrated operation time exceeds the allowable operation time.

11. The control method for the power conversion device according to claim 10,
wherein the step of determining the output suppression or the operation stop of the power conversion device includes steps of
determining the output suppression of the power conversion device if the total of the integrated operation time exceeds the allowable operation time,
determining whether or not a temperature detected after the output suppression of the power conversion device is performed, and a predetermined time elapses is equal to or higher than a predetermined temperature, and
determining the operation stop of the power conversion device if the temperature detected after the predetermined time elapses is equal to or higher than the predetermined temperature.

12. The control method for the power conversion device according to claim 9, further comprising a step of
by the control unit, calculating a remaining time of the allowable operation time of each temperature on the basis of the temperature detected by the temperature detection unit and the operation time integrated at each temperature.

13. The control method for the power conversion device according to claim 9,
wherein the inverter has a semiconductor switching element driven by the driving circuit, and
the control method further comprises a step of, by the control unit, changing the allowable operation time on the basis of a distance between the semiconductor switching element and the temperature detection unit.

14. The control method for the power conversion device according to claim 9, wherein the power conversion device has a current detection unit configured to detect an electric current flowing through the inverter, and
the control method further comprises a step of, by the control unit, changing the allowable operation time on the basis of a current value detected by the current detection unit.

15. The control method for the power conversion device according to claim 9, wherein the control unit determines the allowable operation time of the power conversion device for each predetermined detected temperature range.
